# EUROPEAN PATENT APPLICATION

(11) **EP 1 248 148 A1**
(43) Date of publication of application: **09.10.2002**
(21) Application number: 01303222.2
(22) Date of filing: 05.04.2001
(51) Int. Cl.: G03F 1/14

(54) **Lithographic patterning means with protective layer**

(71) Applicant: ASM LITHOGRAPHY B.V., 5503 LA Veldhoven (NL)
(72) Inventor: The designation of the inventor has not yet been filed
(74) Representative: Leeming, John Gerard

(57) **Abstract**

A patterning means comprising a patterned layer, a frame and a protecting layer is provided for use in lithographic projection apparatus employing 157 nm radiation. The protecting layer having a thickness of less than about 10 µm prevents contaminants to reach the patterned layer. The protecting layer is furthermore made of an inorganic material. Also a method to manufacture such a thin inorganic protecting layer is provided.

## Description

The present invention relates to patterning means for use in a lithographic projection apparatus comprising a patterned layer, a frame and a protecting layer having a thickness of less than 10 µm. The apparatus usually comprises:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from US 5,296,891 and US 5,523,193, which are incorporated herein by reference. In the case of a programmable mirror array, the said support structure may be embodied as a frame or table, for example, which may be fixed or movable as required.
- A programmable LCD array. An example of such a construction is given in US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791, incorporated herein by reference.

As mentioned above, lithographic projection apparatus employ patterning means comprising the patterned layer in order to endow the projection beam with the pattern in its cross-section. The pattern (which is part of the patterned layer) is positioned in a focal plane position in order to properly image the pattern onto a target portion of the substrate. Contaminants, such as particles or adsorbing (carbonaceous) species, may foul the pattern of the patterned layer. As these contaminants are in the focal plane position together with the pattern, they will also be imaged in focus onto the substrate, which results in improper projection of the imaged pattern and which is highly undesirable. For this reason, the patterning means comprises a protecting layer. This protecting layer keeps contaminants out of the focal plane position, hence not affecting the imaged pattern.

In the case of a relatively thick protecting layer having a thickness of about 300 to 1000 µm, this layer generally acts as an optical element, consequently introducing aberrations. These aberrations become particularly significant if 157 nm radiation is employed as opposed to 248 and 193 nm radiation. In such case, aberrations may, for example, cause a drift in the focal plane position or introduce a shift of the imaged pattern in the plane of the substrate surface. Moreover, during a scanning motion the protecting layer may vibrate perpendicular to the plane of the layer. The vibrating movement of the protecting layer leads to variation in aberration level, which is very hard, if not impossible, to correct.

Therefore, relatively thin protecting layers having a thickness of a few microns are contemplated. These layers do not act as optical elements and hence will not introduce aforementioned aberrations. In general, such thin layers are difficult to manufacture. For this reason, protecting layers consisting of organic materials are being manufactured today and considered for use in lithography. However, such organic layers have as a disadvantage that they are generally not sufficiently transparent to 157 nm radiation. And above all, these layers are not stable upon exposure to 157 nm radiation and deteriorate in a short period of time.

It is an object of the present invention to provide an improved patterning means comprising a protecting layer which is substantially transmissive to 157 nm radiation and which is stable upon exposure to the said radiation.

This and other objects are achieved according to the invention in a patterning means as specified in the opening paragraph, which patterning means can be characterized in that the protecting layer comprises an inorganic material.

Such inorganic material can be manufactured sufficiently thin and appeared to be stable upon exposure to 157 nm radiation. Suitable inorganic materials that are transmissive to 157 nm radiation, may be selected from a group comprising SiO₂, F-doped SiO₂, CaF₂, BaF₂, BN and Si₃N₄.

According to a further aspect of the invention there is provided a method of manufacturing a patterning means comprising a patterned layer, a frame and a protecting layer having a thickness of less than 10 µm, the method comprising the steps of:
providing a substantially flat substrate;
depositing onto the substrate the protecting layer which comprises an inorganic material selected from a group comprising SiO₂, F-doped SiO₂, CaF₂, BaF₂ and Si₃N₄.
removing the substrate;
connecting the protecting layer to the frame; and
attaching the frame to a patterned layer.

A method to manufacture a mask for x-ray lithography is proposed in which a thin boron nitride (BN) layer is manufactured. In such case, the BN layer acts as supporting layer for bearing the pattern of the mask. This layer does not stand-alone; on top of the BN layer a polymer *e*.*g*. polyimide film is deposited, onto which a pattern consisting of gold, for example, is provided. More details can be gleaned from S.S. Dana and J.R. Maldonado, J. Vacuum Science and Technology, B4 (1), 1986, 235-239, which is incorporated herein by reference. According to the present invention, only one inorganic layer is required for protecting the pattern on the patterned layer. Next to this requirement, the method must also be suitable for other inorganic materials. As a consequence, for each material specific manufacturing conditions are needed.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a schematic of a patterning means according to the present invention.
Figure 3 represents various steps of a manufacturing method according to the second embodiment.
Figure 4 schematically depicts various steps in an alternative manufacturing method of the second embodiment.

In the Figures, corresponding reference symbols indicate corresponding parts

### Embodiment 1

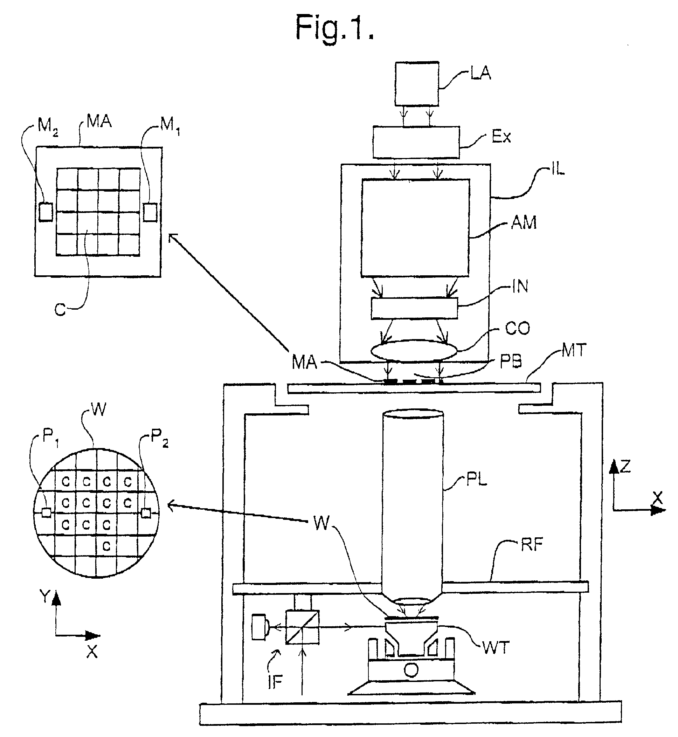

Figure 1 schematically depicts a lithographic projection apparatus according to a particular embodiment of the invention. The apparatus comprises:
. a radiation system Ex, IL, for supplying a projection beam PB of radiation *(e.g.* UV or EUV radiation). In this particular case, the radiation system also comprises a radiation source LA;
. a first object table (mask table) MT provided with a mask holder for holding a mask MA *(e.g.* a reticle), and connected to first positioning means for accurately positioning the mask with respect to item PL;
. a second object table (substrate table) WT provided with a substrate holder for holding a substrate W (*e.g*. a resist-coated silicon wafer), and connected to second positioning means for accurately positioning the substrate with respect to item PL;
. a projection system ("lens") PL *(e.g.* a refractive or catadioptric system, a mirror group or an array of field deflectors) for imaging an irradiated portion of the mask MA onto a target portion C *(e.g.* comprising one or more dies) of the substrate W.
As here depicted, the apparatus is of a transmissive type (*i*.*e*. has a transmissive mask). However, in general, it may also be of a reflective type, for example (with a reflective mask). Alternatively, the apparatus may employ another kind of patterning means, such as a programmable mirror array of a type as referred to above.

The source LA *(e.g.* an excimer laser, an undulator or wiggler provided around the path of an electron beam in a storage ring or synchrotron, a laser-produced plasma source, a discharge source or an electron or ion beam source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i*.*e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv*, in which *M* is the magnification of the lens PL (typically, *M* = 1/4 or 1/5). In this manner, a relatively large target portion C can be exposed, without having to compromise on resolution.

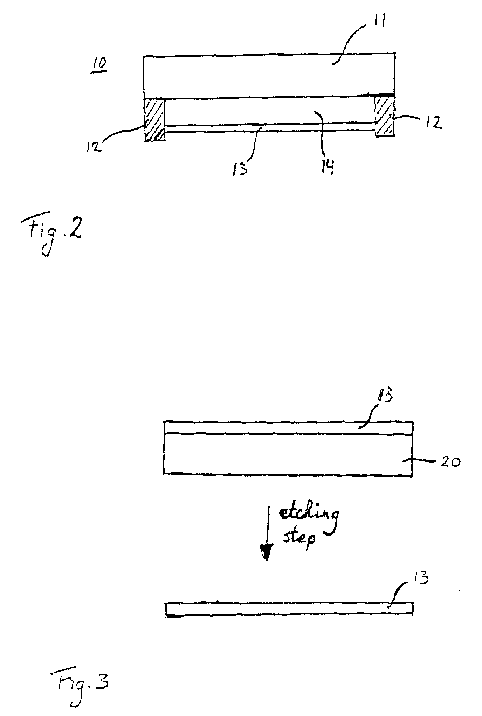

Figure 2 shows a schematic cross-section of a patterning means 10 according to the present invention which may be used in a lithographic projection apparatus. The patterning means comprises a patterned layer 11, a frame 12 and a protecting layer 13. The frame 12 is attached to the layer 11 and the protecting layer 13 is mounted in the frame 12. The protecting layer 13 is located opposite to and facing a pattern (not shown) of the patterned layer 11 where in between a space 14 separates layer 13 from the pattern. In this way, contaminants cannot reach and foul the pattern. As the contaminants, *e.g.* particles or adsorbed (carbonaceous) species, adsorb on the protecting layer, they are out of the focal plane position of the pattern and are not projected onto the substrate.

The protecting layer 13 has a thickness of less than 10 µm, preferably about 3 µm or less. With such thickness values, the layer 13 does not act as an optical element, and hence does not cause undesirable and uncontrollable optical distortion effects. Additionally, the layer 13 is made of an inorganic material which is transmissive to the applied radiation, for example, 157 nm radiation. Suitable materials may be compounds selected from a group comprising SiO₂, F-doped SiO₂, CaF₂, BaF₂, BN and Si₃N₄.

### Embodiment 2

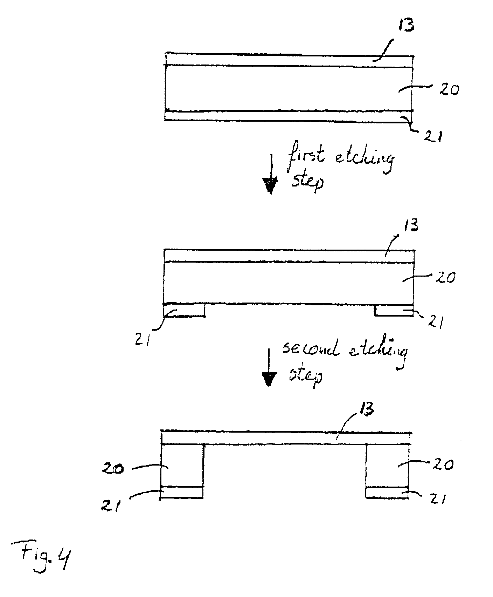

A manufacturing method is schematically depicted in Figure 3. According to this method, thin inorganic protecting layers (of embodiment 1) can be manufactured by first taking a substantially flat substrate *e.g.* a silicon wafer. Onto the wafer 20 the inorganic material is deposited by physical vapor deposition or by chemical vapor deposition, for example. With these methods it is also possible to first deposit an intermediate compound which is then converted to the desired inorganic material. In the case of a boron nitride (BN) layer, diborane hydride (B₂H₆) and ammonia (NH₃) are provided as gases in a reaction chamber which are then upon exposure to a heated silicon wafer 20 converted to boron nitride.

Subsequently, the silicon wafer is removed *e.g.* by reactive ion etching using tetrafluoromethane (CF₄) and/or oxygen (O₂) or by chemical etching with an acidic solution of *e.g*. a mixture of hydrogen fluoride (HF), nitric acid (HNO₃) or acetic acid (CH₃COOH). It is also possible to remove the silicon via a combination of both reactive ion and chemical etching, which are subsequently performed in random order. It is preferable to employ etching methods which only or at least to a much greater extent affect the silicon wafer 20 and not the protecting layer 13. If the silicon wafer is completely removed, the protecting layer 13 can be mounted in a frame 12. The frame is in turn attached to the patterned layer 11.

The silicon wafer 20 can also be removed only partially as is shown in Figure 4. Inorganic material is deposited on both sides of the silicon wafer resulting in a protecting layer 13 and a back side layer 21. The material of layers 13 and 21 may differ or be the same. In a first etching step part of the inorganic material of back side layer 21 is selectively etched away. In a subsequent etching step only silicon 20 which is not covered by the inorganic layer 21 is selectively removed provided that layer 21 is substantially insensitive to this etching step. In this way, a window of silicon 20 is created surrounding the inorganic protecting layer 13. This relatively thick silicon window 20 can be used as (part of) a frame 12.

Whilst specific embodiments of the invention have been described above, it will be appreciated that the invention may be practiced otherwise than as described. The description is not intended to limit the invention.

## Claims

1. A patterning means for use in a lithographic projection apparatus comprising a patterned layer, a frame and a protecting layer having a thickness of less than 10 µm **characterized in that** the protecting layer comprises an inorganic material.

2. A patterning means according to claim 1 **characterized in that** the inorganic material is at least one material selected from a group comprising SiO₂, F-doped SiO₂, CaF₂, BaF₂, BN and Si₃N₄.

3. A patterning means according to claim 1 or 2, **characterized in that** the patterning means is a mask.

4. A method of manufacturing a patterning means comprising a patterned layer, a frame and a protecting layer having a thickness of less than 10 µm, the method comprising the steps of:
providing a substantially flat substrate;
depositing onto the substrate the protecting layer which comprises an inorganic material selected from a group comprising SiO₂, F-doped SiO₂, CaF₂, BaF₂ and Si₃N₄.
removing the substrate;
connecting the protecting layer to the frame; and
attaching the frame to a patterned layer.

5. A method according to claim 4 **characterized in that** the frame comprises part of the substrate.
